# DEMANDE DE BREVET EUROPEEN

(11) **EP 4 481 342 A1**
(43) Date de publication de la demande: **25.12.2024**
(21) Numéro de dépôt: 24182162.8
(22) Date de dépôt: 14.06.2024
(51) Int. Cl.: G01J 5/02, G01J 5/0802, G01J 5/20

(54) **DETECTEUR BOLOMETRIQUE**

(30) Priorité: 22.06.2023 FR 2306466
(71) Demandeur: Commissariat à l'Energie Atomique et aux Energies Alternatives, 75015 Paris (FR)
(72) Inventeur: PERRILLAT-BOTTONET, Thomas, 38054 GRENOBLE CEDEX 09 (FR); YON, Jean-Jacques, 38054 GRENOBLE CEDEX 09 (FR); POCAS, Stéphane, 38054 GRENOBLE CEDEX 09 (FR)
(74) Mandataire: Cabinet Beaumont

(57) **Abrégé**

La présente description concerne un détecteur bolométrique (100) comprenant une pluralité de pixels comportant chacun une planche bolométrique (101) suspendue au-dessus d'un substrat (103) par des piliers de soutien (107), le détecteur comprenant en outre, pour au moins un desdits pixels, un filtre à mode guidé comprenant un guide d'ondes planaire (111) en appui sur les piliers de soutien (107) et un réseau de diffraction (113) situé sur et en contact avec le guide d'ondes.

## Description

### Domaine technique

La présente description concerne de façon générale le domaine des dispositifs électroniques, plus particulièrement les détecteurs bolométriques.

### Technique antérieure

Des détecteurs ou imageurs bolométriques fonctionnant dans le domaine de l'infrarouge ont été proposés. De tels détecteurs sont par exemple capables de capter un rayonnement infrarouge dans une gamme de longueurs d'onde comprise entre quelques micromètres et plusieurs centaines de micromètres, par exemple comprise entre 3 et 20 µm, par exemple plus précisément comprise entre 7 et 14 µm (bande LWIR, de l'anglais « LongWave InfraRed » - infrarouge à grande longueur d'onde).

Parmi les détecteurs bolométriques existants, des détecteurs multispectraux ont en particulier été proposés. À la différence des détecteurs dits « large bande » ou « pleine bande », adaptés à former une unique image d'une scène en exploitant intégralement leur plage spectrale de sensibilité, les détecteurs multispectraux sont capables de produire plusieurs images d'une même scène en exploitant différentes bandes, ou sous-plages, à l'intérieur de leur plage spectrale de sensibilité. Cela permet par exemple aux détecteurs multispectraux de déterminer, avec peu d'hypothèses sur l'émissivité, la température en plusieurs endroits de la scène à imager (thermographie absolue). L'information acquise par les détecteurs bolométriques multispectraux peut par ailleurs être mise à profit pour détecter ou distinguer des espèces chimiques présentes dans la scène. Un exemple d'application de cette technique est la détection de gaz, par exemple la détection de fuites de gaz sur une installation industrielle.

Des détecteurs bolométriques multispectraux comprenant une roue à filtres placée en vis-à-vis d'un capteur bolométrique adapté à acquérir une image pour chaque filtre de la roue ont été proposés. Ces détecteurs sont toutefois encombrants et requièrent que la scène demeure relativement immobile, ou constante, pendant la durée d'acquisition des images. On connaît par ailleurs d'autres détecteurs bolométriques multispectraux, plus compacts et comprenant un groupe de filtres optiques disposé en vis-à-vis d'un capteur bolométrique, certains filtres étant adaptés à transmettre un rayonnement incident majoritairement dans une première plage de longueurs d'onde vers certains bolomètres du capteur et d'autres filtres étant adaptés à transmettre un rayonnement incident majoritairement dans au moins une deuxième plage de longueurs d'onde, différente de la première plage de longueurs d'onde, vers d'autres bolomètres du capteur. Chaque filtre peut dans ce cas comporter, pour chaque pixel, des éléments situés à l'intérieur d'une cavité quart d'onde du pixel, placés au niveau d'un absorbeur du pixel ou déportés au-dessus du pixel. Ce dernier cas évite d'introduire des modifications impactant la membrane du pixel bolométrique ou d'ajouter de nouveaux éléments dans la cavité quart d'onde. Cela facilite l'adaptation des procédés connus de réalisation de pixels bolométriques pour la réalisation de tels détecteurs.

Une solution proposée de filtrage au-dessus des pixels est basée sur le principe dit de « résonance de mode guidé ». Un filtre à résonance de mode guidé, ou filtre GMR (de l'anglais « Guided Mode Résonance »), comprend typiquement un guide d'ondes planaire couplé à un réseau de diffraction en amplitude ou en phase. Le guide d'ondes planaire est par exemple formé dans une couche mince d'indice de réfraction n élevé (typiquement supérieur à 1,5) et transparente dans le domaine de l'infrarouge, la couche présentant en outre une épaisseur e adaptée à la longueur d'onde médiane λ de la bande d'intérêt (e = λ/(2n)). Par ailleurs, le réseau de diffraction est adapté à coupler sélectivement un rayonnement infrarouge dont la longueur d'onde présente un premier ordre de diffraction correspondant à l'angle d'acceptance du guide d'ondes, la période du réseau de diffraction permettant de sélectionner la longueur d'onde de résonance. Le brevet français FR 3054318 décrit un exemple de dimensionnement d'un filtre GMR, son couplage à un pixel bolométrique infrarouge et des modes de réalisation de l'ensemble.

Le fonctionnement correct d'un filtre GMR dépend fortement du respect de la périodicité de la structure formée par le réseau de diffraction. Dans le cas d'une matrice bolométrique présentant un faible pas de pixel et dont les motifs du réseau de diffraction sont individualisés pour chaque pixel, cette périodicité peut s'avérer difficile à respecter. À titre d'exemple, pour produire une résonance centrée autour de 10 µm, la période du réseau de diffraction est de l'ordre de 3,5 µm. Dans le cas d'un pas de pixel égal à environ 12 µm, le nombre de motifs par ligne ou par colonne du réseau de diffraction est alors, pour chaque pixel, strictement inférieur à 4. Dans ce cas, la réponse spectrale du filtre GMR s'écarte fortement d'un cas idéal où l'extension latérale du réseau de diffraction est supposée infinie, et présente des résonances parasites multiples. Cela entraîne une dégradation des performances du détecteur bolométrique multispectral, se traduisant notamment par une baisse des performances de réjection des pixels et l'apparition de phénomènes de diaphonie, ou « crosstalk optique », tendant à limiter l'efficacité des algorithmes de reconstruction de température, à fausser l'interprétation de la nature des composés chimiques présents dans la scène, etc.

### Résumé de l'invention

Il existe un besoin de pallier tout ou partie des inconvénients des détecteurs bolométriques existants.

Pour cela, un mode de réalisation prévoit un détecteur bolométrique comprenant une pluralité de pixels comportant chacun une planche bolométrique suspendue au-dessus d'un substrat par des piliers de soutien, le détecteur comprenant en outre, pour au moins un desdits pixels, un filtre à mode guidé comprenant un guide d'ondes planaire en appui sur les piliers de soutien et un réseau de diffraction situé sur et en contact avec le guide d'ondes.

Selon un mode de réalisation, le filtre à mode guidé comprend des éléments de support en appui sur les piliers de soutien.

Selon un mode de réalisation, chaque élément de support comprend une région électriquement conductrice dont les flancs et le fond sont revêtus d'une couche électriquement isolante.

Selon un mode de réalisation, chaque élément de support est constitué d'une seule région diélectrique.

Selon un mode de réalisation, au moins deux pixels adjacents du détecteur comprennent le filtre à mode guidé, les guides d'ondes planaires desdits pixels étant isolés optiquement par une région électriquement conductrice dont les flancs et le fond sont revêtus d'une couche électriquement isolante.

Selon un mode de réalisation, chaque élément de support comprend une région diélectrique en un premier matériau, les flancs et le fond de ladite région étant revêtus d'une couche isolante en un deuxième matériau, différent du premier matériau.

Selon un mode de réalisation, le premier matériau est le silicium amorphe.

Selon un mode de réalisation, le deuxième matériau est l'alumine.

Selon un mode de réalisation, au moins deux pixels adjacents comprennent le filtre à mode guidé, les guides d'ondes planaires de desdits pixels étant isolés optiquement par une région électriquement conductrice.

Selon un mode de réalisation, la région électriquement conductrice et le réseau de diffraction sont en un même matériau, de préférence un métal.

Selon un mode de réalisation, la région électriquement conductrice et le réseau de diffraction sont en des matériaux, de préférence des métaux, différents.

Selon un mode de réalisation, le réseau de diffraction comprend une pluralité de plots situés sur et en contact avec la face supérieure du guide d'ondes planaire.

Un mode de réalisation prévoit un procédé de fabrication d'un détecteur bolométrique tel que décrit, le procédé comprenant les étapes suivantes :
a) former les piliers de soutien et les planches bolométriques au-dessus du substrat ;
b) déposer une première couche sacrificielle du côté de la face supérieure de la structure ;
c) former, pour ledit au moins un desdits pixels, le guide d'ondes planaire et le réseau de diffraction ;
d) former des vias dans toute l'épaisseur de la première couche diélectrique à l'aplomb de chaque pilier de soutien ;
e) déposer une deuxième couche isolante du côté de la face supérieure de la structure ; et
f) déposer une couche électriquement conductrice du côté de la face supérieure de la structure.

Selon un mode de réalisation, l'étape f) est mise en oeuvre après l'étape e).

Selon un mode de réalisation, l'étape f) est mise en oeuvre avant l'étape c).

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figure 1A, figure 1B, figure 1C, figure 1D, figure 1E, figure 1F et figure 1G illustrent, par des vues de dessus et des vues latérales et en coupe, schématiques et partielles, des étapes successives d'un exemple de procédé de fabrication d'un détecteur bolométrique selon un mode de réalisation ;
les figure 2A, figure 2B, figure 2C, figure 2D et figure 2E illustrent, par des vues de dessus et des vues latérales et en coupe, schématiques et partielles, des étapes successives d'un exemple de procédé de fabrication d'un détecteur bolométrique selon un mode de réalisation ;
les figure 3A, figure 3B, figure 3C, figure 3D, figure 3E, figure 3F, figure 3G, figure 3H, figure 3I, figure 3J et figure 3K illustrent, par des vues de dessus et des vues latérales et en coupe, schématiques et partielles, des étapes successives d'un exemple de procédé de fabrication d'un détecteur bolométrique selon un mode de réalisation ;
la figure 4A et la figure 4B illustrent, par des vues latérales et en coupe, schématiques et partielles, une étape d'une variante du procédé de fabrication du détecteur bolométrique des figures 3A à 3K ; et
la figure 5A et la figure 5B sont des graphiques illustrant des spectres d'absorption de pixels bolométriques.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les étapes de réalisation du substrat, des planches bolométriques et des piliers de soutien n'ont pas été détaillées, les modes de réalisation décrits étant compatibles avec les procédés usuels de réalisation de ces éléments.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % près, de préférence à 5 % près.

L'expression « transmittance d'une couche » désigne un rapport entre l'intensité du rayonnement sortant d'une couche et l'intensité du rayonnement entrant dans la couche. Dans la suite de la description, une couche ou un film est dit opaque à un rayonnement lorsque la transmittance du rayonnement au travers de la couche ou du film est inférieure à 10 %. Dans la suite de la description, une couche ou un film est dit transparent à un rayonnement lorsque la transmittance du rayonnement au travers de la couche ou du film est supérieure à 10 %.

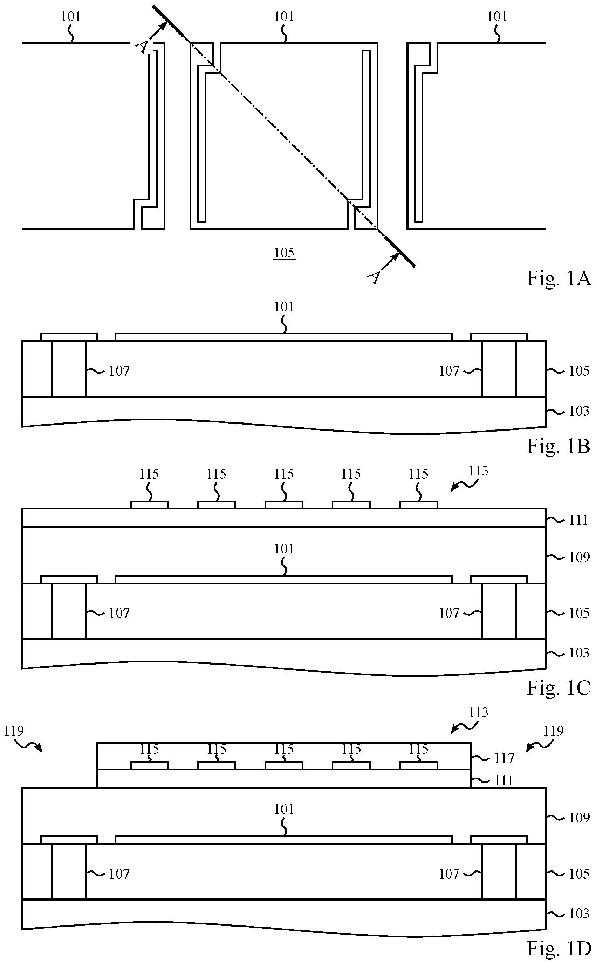

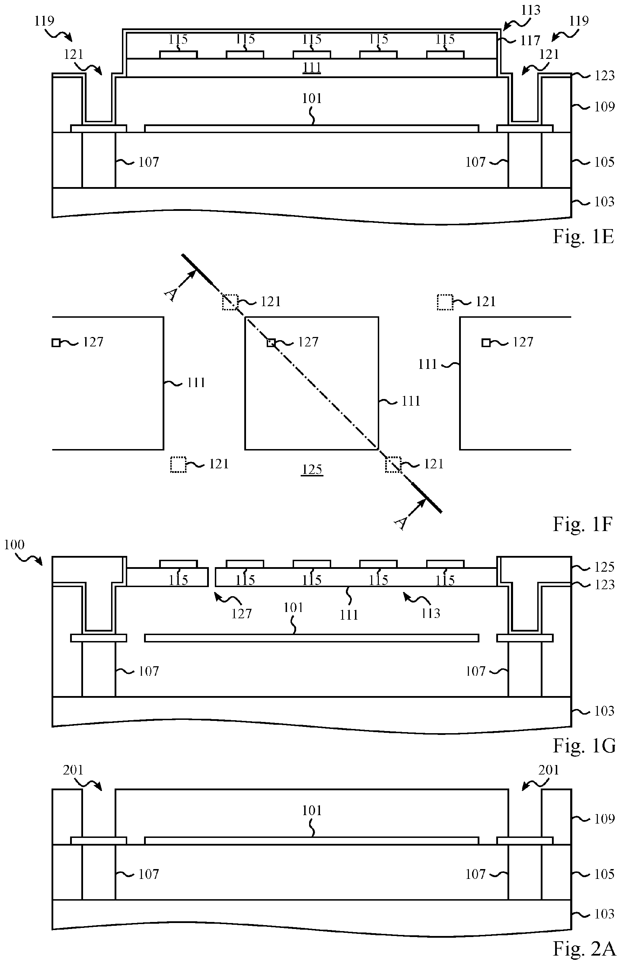

Les figure 1A, figure 1B, figure 1C, figure 1D, figure 1E, figure 1F et figure 1G illustrent, par des vues de dessus et des vues latérales et en coupe, schématiques et partielles, des étapes successives d'un exemple de procédé de fabrication d'un détecteur bolométrique 100 selon un mode de réalisation.

La figure 1A et la figure 1B sont respectivement une vue de dessus et une vue latérale et en coupe selon le plan AA de la figure 1A, schématiques et partielles, d'une étape comprenant la formation d'une matrice de pixels bolométriques.

Dans l'exemple représenté, chaque pixel comporte une planche bolométrique 101 située au-dessus d'un substrat 103, par exemple une plaquette ou un morceau de plaquette. Le substrat 103 est par exemple en un matériau semiconducteur, par exemple le silicium. Le substrat 103 est par exemple de type CMOS (de l'anglais « Complementary Metal-Oxide-Semiconductor » - métal-oxyde-semiconducteur complémentaire). Dans ce cas, des transistors, des éléments de reprise de contacts, des vias conducteurs, etc. (non détaillés en figures 1A et 1B), adaptés à commander les pixels de la matrice et à acquérir des signaux provenant des pixels, sont par exemple formés dans le substrat 103. Bien que cela n'ait pas été détaillé en figures 1A et 1B, le substrat 103 comprend par exemple en outre un réflecteur permettant de former une cavité quart d'onde avec la planche bolométrique 101.

Dans l'exemple illustré, une couche 105 revêt une face du substrat 103 (la face supérieure du substrat 103, dans l'orientation de la figure 1B). La couche 105 est par exemple une couche sacrificielle destinée à être éliminée au moins partiellement lors du procédé de réalisation du détecteur bolométrique 100. À titre d'exemple, la couche 105 est une couche en un matériau électriquement isolant, par exemple un oxyde de silicium, obtenu par exemple par l'intermédiaire d'un précurseur tel que l'orthosilicate de tétraéthyle (TEOS). Dans l'exemple représenté, les planches bolométriques 101 revêtent la face de la couche 105 opposée au substrat 103 (la face supérieure de la couche 105, dans l'orientation de la figure 1B).

Dans l'exemple représenté, des piliers de soutien 107 des planches bolométriques 101 s'étendent verticalement dans l'épaisseur de la couche 105, depuis sa face supérieure jusqu'au substrat 103. Les piliers de soutien 107 forment des pieds verticaux orthogonaux à la face supérieure du substrat 103 et sont destinés à suspendre les planches bolométriques 101 au-dessus du substrat 103 à l'issue des étapes de fabrication du détecteur bolométrique 100, par exemple après élimination de la couche 105, les piliers de soutien 107 reposant sur le substrat 103. Dans l'exemple illustré, chaque planche bolométrique 101 présente, en vue de dessus, un pourtour de forme sensiblement carrée et repose sur deux piliers de soutien 107 disposés au voisinage de deux coins diagonalement opposés de la planche bolométrique 101. Cet exemple n'est toutefois pas limitatif, les planches bolométriques 101 pouvant, à titre de variante, présenter un pourtour de forme quelconque et être en appui sur un nombre quelconque, par exemple supérieur ou égal à deux, de piliers de soutien 107 disposés de façon quelconque. Dans l'exemple représenté, des bras de soutien permettent de solidariser mécaniquement chaque planche bolométrique 101 avec les piliers de soutien 107 correspondants. Les bras de soutien permettent en outre de relier ou de connecter électriquement la planche bolométrique 101 au substrat 103 de manière à permettre une lecture d'un signal.

La figure 1C est une vue latérale et en coupe selon le plan AA de la figure 1A, schématique et partielle, illustrant une structure obtenue à l'issue d'une étape ultérieure de fabrication du détecteur bolométrique 100.

Au cours de cette étape, une couche sacrificielle 109 est déposée du côté de la face supérieure de la structure précédemment décrite en relation avec la figure 1B. La couche 109 revêt la face supérieure et les faces latérales des planches bolométriques 101, et des parties de la face supérieure de la couche 105 non revêtues par les planches bolométriques 101. La couche 109 est par exemple une couche sacrificielle destinée à être éliminée au moins partiellement lors du procédé de réalisation du détecteur bolométrique 100. La couche 109 présente par exemple une épaisseur comprise entre 500 nm et 2,5 µm, par exemple égale à environ 1,5 µm. À titre d'exemple, la couche 109 est une couche en un matériau électriquement isolant, par exemple un oxyde de silicium, obtenu par exemple à partir d'un précurseur tel que l'orthosilicate de tétraéthyle. La couche 109 est par exemple en le même matériau que la couche 105.

Par ailleurs, une couche diélectrique 111 est déposée sur la couche 109 au cours de cette étape. Dans l'orientation de la figure 1C, la couche diélectrique 111 revêt la face supérieure de la couche 109. La couche diélectrique 111 est une couche diélectrique destinée à former un guide d'ondes planaire au-dessus des planches bolométriques 101. La couche diélectrique 111 présente par exemple un indice de réfraction n et une épaisseur e égale à environ À/(2n), où λ représente la longueur d'onde d'intérêt du détecteur bolométrique 100. À titre d'exemple, la couche diélectrique 111 est en silicium amorphe et présente une épaisseur e comprise entre 500 nm et 2,5 µm, par exemple égale à environ 1,6 µm pour une gamme de longueurs d'onde d'intérêt λ du détecteur bolométrique 100 comprise entre 8 et 14 µm.

Par ailleurs, une couche électriquement conductrice est déposée sur la couche diélectrique 111 au cours de cette étape. Un réseau de diffraction 113 est ensuite formé à partir de la couche électriquement conductrice, par exemple par photolithographie puis gravure sélective de la couche conductrice avec arrêt sur la couche diélectrique 111. Dans l'exemple représenté, le réseau de diffraction 113 comporte une pluralité de plots 115, le réseau de diffraction 113 étant alors par exemple un réseau de diffraction « en amplitude ». Le réseau de diffraction 113 présente par exemple une géométrie, par exemple un pas, individualisé pour chaque pixel, c'est-à-dire que le pas du réseau de diffraction 113 peut varier d'un pixel à l'autre. La couche électriquement conductrice dans laquelle est formé le réseau de diffraction 113 présente par exemple une épaisseur comprise entre 10 et 400 nm, par exemple égale à environ 50 nm. Les plots 115 présentent par exemple une épaisseur sensiblement égale à celle de la couche conductrice dans laquelle ils sont formés. À titre d'exemple, la couche électriquement conductrice est en un métal, par exemple l'aluminium, le tungstène, l'or ou l'argent, ou en un alliage métallique, par exemple un alliage à base d'aluminium et de silicium (présentant par exemple une teneur en silicium de l'ordre de 1 %).

La figure 1D est une vue latérale et en coupe selon le plan AA de la figure 1A, schématique et partielle, illustrant une structure obtenue à l'issue d'une étape ultérieure de fabrication du détecteur bolométrique 100.

Au cours de cette étape, une couche 117 est déposée du côté de la face supérieure de la structure précédemment décrite en relation avec la figure 1C. La couche 117 revêt la face supérieure et les faces latérales des plots 115 du réseau de diffraction 113, et des parties de la face supérieure de la couche diélectrique 111 non revêtues par les plots 115. La couche 117 présente par exemple une épaisseur comprise entre 100 et 500 nm, par exemple égale à environ 200 nm. À titre d'exemple, la couche 117 est en un matériau électriquement isolant, par exemple un oxyde de silicium, obtenu par exemple à partir d'un précurseur tel que l'orthosilicate de tétraéthyle. La couche 117 est par exemple en le même matériau que la couche 109.

Par ailleurs, au cours de cette étape, des tranchées 119 sont formées dans les couches 117 et 111. Les tranchées 119 s'étendent verticalement dans l'épaisseur des couches 117 et 111 depuis la face supérieure de la couche 117 jusqu'à la face supérieure de la couche 109. Dans l'exemple représenté, chaque tranchée 119 présente, en vue de dessus, une forme annulaire délimitant un îlot comprenant une partie de la couche diélectrique 111, une partie de la couche 117 et une partie du réseau de diffraction 113 situées en vis-à-vis de l'une des planches bolométriques 101. Les tranchées 119 associées aux différentes planches bolométriques 101 peuvent comporter des parties communes, les tranchées 119 formant par exemple un quadrillage, en vue de dessus. À titre d'exemple, les tranchées 119 sont formées par une étape de photolithographie suivie d'une étape de gravure de la couche 117 puis d'une étape de gravure de la couche diélectrique 111.

La figure 1E est une vue latérale et en coupe selon le plan AA de la figure 1A, schématique et partielle, illustrant une structure obtenue à l'issue d'une étape ultérieure de fabrication du détecteur bolométrique 100.

Au cours de cette étape, des vias 121 sont formés dans la couche 109, à l'aplomb des piliers de soutien 107. Dans l'exemple illustré, les vias 121 traversent toute l'épaisseur de la couche 109, c'est-à-dire s'étendent verticalement depuis la face supérieure de la couche 109 jusqu'à la face supérieure des piliers de soutien 107. Dans l'exemple représenté, les vias 121 présentent des dimensions latérales sensiblement égales à celles des piliers de soutien 107.

À titre d'exemple, les vias 121 sont formés par un procédé comprenant les étapes successives suivantes :
a) dépôt d'une couche en un matériau carboné, par exemple appliqué par un étendage en rotation (« Spin-on Carbon » - SoC, en anglais), du côté de la face supérieure de la structure décrite ci-dessus en relation avec la figure 1D ;
b) fluage du matériau carboné par chauffage, par exemple à une température égale à environ 400 °C ;
c) dépôt d'une couche diélectrique, par exemple une couche minérale en nitrure de silicium ou en oxyde de silicium, revêtant la face supérieure de la couche en matériau carboné ;
d) dépôt d'une couche en une résine photosensible revêtant la face supérieure de la couche diélectrique ;
e) formation d'ouvertures dans la couche diélectrique, par photolithographie puis gravure à travers des ouvertures préalablement formées dans la couche en résine photosensible, puis élimination de la couche en résine photosensible, par exemple par décapage (« stripping », en anglais) ;
f) gravure auto-alignée de la couche en matériau carboné à travers les ouvertures formées dans la couche diélectrique au cours de l'étape e), la couche diélectrique jouant le rôle d'un masque dur (couche mince minérale) lors de cette étape, puis élimination de la couche diélectrique ;
g) gravure de la couche 109 à travers les ouvertures formées dans la couche en matériau carboné au cours de l'étape f) avec arrêt sur les piliers de soutien 107 des planches bolométriques 101, la couche en matériau carboné jouant le rôle d'un masque dur lors de cette étape ; et
h) élimination de la couche en matériau carboné, par exemple par exposition à un plasma à base d'oxygène.

Par ailleurs, au cours de cette étape, une couche isolante 123 est déposée du côté de la face supérieure de la structure. La couche isolante 123 permet d'isoler les bolomètres par rapport à la couche diélectrique 111. Dans l'orientation de la figure 1E, la couche isolante 123 revêt les faces latérales et le fond des vias 121, les parties de la face supérieure de la couche 109 non revêtues par la couche diélectrique 111, les faces latérales de la couche diélectrique 111, et la face supérieure et les faces latérales de la couche 117. La couche isolante 123 présente par exemple une épaisseur comprise entre 20 et 200 nm. À titre d'exemple, la couche isolante 123 est en un matériau résistant à une opération ultérieure de libération par exposition à de l'acide fluorhydrique en phase vapeur, par exemple le nitrure d'aluminium ou l'alumine. La couche isolante 123 est par exemple une couche d'alumine, par exemple formée par dépôt de couches atomiques (« Atomic Layer Déposition » - ALD, en anglais), et présentant une épaisseur égale à environ 20 ou 40 nm.

La figure 1F et la figure 1G sont respectivement une vue de dessus et une vue latérale et en coupe selon le plan AA de la figure 1F, schématiques et partielles, illustrant une structure obtenue à l'issue d'une étape ultérieure de fabrication du détecteur bolométrique 100. Le réseau de diffraction 113 et les couches 117 et 123 n'ont pas été représentés en figure 1F afin de ne pas surcharger le dessin.

Au cours de cette étape, une couche 125 est déposée du côté de la face supérieure de la structure précédemment décrite en relation avec la figure 1E. Dans l'exemple illustré, la couche 125 revêt la couche isolante 123. La couche 125 comble les tranchées 119 et les vias 121, formant ainsi des éléments ou pieds de support d'un filtre de résonance à mode guidé, ou filtre GMR, comprenant le guide d'ondes 111 et le réseau de diffraction 113. La couche 125 fait par ailleurs office de couche isolante optiquement entre les différents pixels du détecteur bolométrique 100. À titre d'exemple, la couche 125 est en un métal, par exemple le tungstène, ou en un alliage métallique.

Par ailleurs, au cours de cette étape, la couche 117 et la couche 125 sont amincies, par exemple par CMP (de l'anglais « Chemical and Mechanical Polishing » - polissage mécano-chimique), la portion de la couche 123 en contact avec la face supérieure de la couche 117 étant éliminée par l'opération de CMP. La couche 117 présente alors une épaisseur légèrement supérieure à celle des plots 115 du réseau de diffraction 113 et seules des parties de la couche 125 comblant les tranchées 119 et les vias 121 sont conservées.

Par ailleurs, au cours de cette étape, des évents 127 de libération sont formés dans l'épaisseur des couches 117 et 111, par exemple par photolithographie puis gravure. Une libération par exposition à de l'acide fluorhydrique en phase vapeur est alors par exemple ensuite mise en oeuvre de sorte à éliminer les couches 105, 109 et 117, ce qui a pour effet de suspendre les planches bolométriques 101 du détecteur 100 au-dessus du substrat 103. Dans cet exemple, le filtre GMR du détecteur bolométrique 100 est alors en appui sur les piliers de soutien 107 des planches bolométriques 101, la face inférieure de chaque élément de support du filtre GMR étant sur et en contact avec la face supérieure du pilier de soutien 107 situé en vis-à-vis.

Dans cet exemple, les parties de la couche 125 qui subsistent à l'issue des étapes de fabrication du détecteur bolométrique 100 sont interconnectées. Les parties de la couche 125 jouent par exemple le rôle d'un isolateur optique permettant de limiter les phénomènes de diaphonie, ou « crosstalk optique », entre les différents pixels du détecteur bolométrique 100. Dans l'exemple représenté, les éléments de support du filtre GMR comprennent une région électriquement conductrice, en l'espèce une partie de la couche 125, dont les flancs et le fond sont revêtus d'une couche électriquement isolante, en l'espèce une partie de la couche 123.

Dans l'exemple illustré, l'isolateur optique présente, en vue de dessus, une forme annulaire. Cela permet d'atteindre une performance optique optimale.

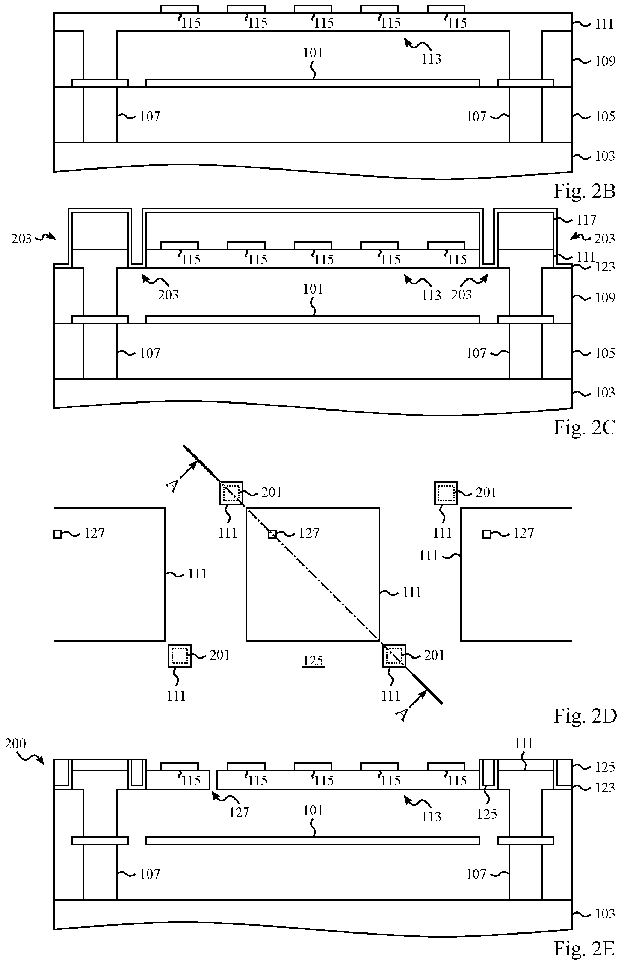

Les figure 2A, figure 2B, figure 2C, figure 2D et figure 2E illustrent, par des vues de dessus et des vues latérales et en coupe, schématiques et partielles, des étapes successives d'un exemple de procédé de fabrication d'un détecteur bolométrique 200 selon un mode de réalisation.

Le procédé de réalisation du détecteur bolométrique 200 présente des similitudes avec le procédé de réalisation du détecteur bolométrique 100 détaillé ci-dessus. Le procédé de réalisation du détecteur bolométrique 200 diffère du procédé de réalisation du détecteur bolométrique 100 en ce que, dans le procédé de réalisation du détecteur bolométrique 200, la couche 109 est gravée, en vue de former ultérieurement les éléments de support du filtre GMR, préalablement au dépôt de la couche diélectrique 111.

La figure 2A est une vue latérale et en coupe selon le plan AA de la figure 1A, schématique et partielle, illustrant une structure obtenue à l'issue d'une étape de fabrication du détecteur bolométrique 200 comprenant le dépôt, du côté de la face supérieure de la structure précédemment décrite en relation avec les figures 1A et 1B, de la couche 109.

Par ailleurs, au cours de cette étape, des vias 201 sont formés dans la couche 109, à l'aplomb des piliers de soutien 107. Dans l'exemple illustré, les vias 201 traversent toute l'épaisseur de la couche 109 et s'étendent verticalement depuis la face supérieure de la couche 109 jusqu'à la face supérieure des piliers de soutien 107. Dans l'exemple représenté, les vias 201 présentent des dimensions latérales sensiblement égales à celles des piliers de soutien 107. Les vias 201 sont par exemple formés par photolithographie puis gravure, avec arrêt sur la couche supérieure des piliers de soutien 107.

La figure 2B est une vue latérale et en coupe selon le plan AA de la figure 1A, schématique et partielle, illustrant une structure obtenue à l'issue d'une étape ultérieure de fabrication du détecteur bolométrique 200.

Au cours de cette étape, la couche diélectrique 111 est déposée du côté de la face supérieure de la structure précédemment décrite en relation avec la figure 2A. Dans l'exemple représenté, la couche diélectrique 111 comble, c'est-à-dire remplit intégralement, les vias 201 et revêt la face supérieure de la couche 109. Cet exemple n'est toutefois pas limitatif, la couche diélectrique 111 pouvant, à titre de variante, revêtir les flancs et le fond des vias 201 sans les combler.

Par ailleurs, au cours de cette étape, les plots 115 du réseau de diffraction 113 sont formés sur la face supérieure de la couche diélectrique 111, par exemple comme exposé précédemment en relation avec la figure 1C.

La figure 2C est une vue latérale et en coupe selon le plan AA de la figure 1A, schématique et partielle, illustrant une structure obtenue à l'issue d'une étape ultérieure de fabrication du détecteur bolométrique 200.

Au cours de cette étape, la couche 117 est déposée du côté de la face supérieure de la structure précédemment décrite en relation avec la figure 2B.

Par ailleurs, au cours de cette étape, des tranchées 203 sont formées dans la couche 117 et dans la couche diélectrique 111. Dans l'exemple représenté, les tranchées 203 s'étendent verticalement dans l'épaisseur des couches 117 et 111, depuis la face supérieure de la couche 117, jusqu'à la face supérieure de la couche 109. Les tranchées 203 présentent par exemple, en vue de dessus, une forme annulaire délimitant des parties des couches 111 et 117 situées à l'aplomb de la planche bolométrique 101, et des parties des couches 111 et 117 situées à l'aplomb des piliers de soutien 107. Ainsi, à la différence du mode de réalisation précédemment décrit en relation avec les figures 1A à 1G, la géométrie des tranchées 203 épargne les zones d'appui, aucune tranchée 203 n'étant, dans ce cas, située à l'aplomb des éléments de support du filtre GMR.

Par ailleurs, au cours de cette étape, la couche isolante 123 est déposée du côté de la face supérieure de la structure. Dans l'exemple illustré, la couche 123 revêt les flancs et le fond des tranchées 203 ainsi que la face supérieure de la couche 117.

La figure 2D et la figure 2E sont respectivement une vue de dessus et une vue latérale et en coupe selon le plan AA de la figure 2D, schématiques et partielles, illustrant une structure obtenue à l'issue d'une étape ultérieure de fabrication du détecteur bolométrique 200. Le réseau de diffraction 113 et les couches 117 et 123 n'ont pas été représentés en figure 2D afin de ne pas surcharger le dessin.

Au cours de cette étape, la couche 125 est déposée du côté de la face supérieure de la structure précédemment décrite en relation avec la figure 2C. Dans l'exemple illustré, la couche 125 revêt la couche isolante 123. La couche 125 comble les tranchées 203 et fait office de couche isolante optiquement entre les différents pixels du détecteur bolométrique 200.

Par ailleurs, au cours de cette étape, la couche 117 et la couche 125 sont amincies, par exemple par CMP, la portion de la couche 123 en contact avec la face supérieure de la couche 117 étant éliminée par l'opération de CMP. La couche 117 présente alors une épaisseur résiduelle légèrement supérieure à celle des plots 115 du réseau de diffraction 113, et seules des parties de la couche 125 comblant les tranchées 203 sont conservées.

Par ailleurs, au cours de cette étape, les évents 127 de libération sont formés dans l'épaisseur des couches 117 et 111, par exemple par photolithographie puis gravure. Une libération par exposition à de l'acide fluorhydrique en phase vapeur est alors par exemple ensuite mise en oeuvre de sorte à éliminer les couches 105, 109 et 117, ce qui a pour effet de suspendre les planches bolométriques 101 du détecteur 200 au-dessus du substrat 103.

Dans cet exemple, les parties de la couche 125 qui subsistent à l'issue des étapes de fabrication du détecteur bolométrique 200 sont interconnectées, et les éléments de support du filtre GMR sont intégralement réalisés en un matériau diélectrique, en l'espèce le matériau de la couche 111. L'isolation optique entre les pixels du détecteur 200 est assurée par les parties de la couche 125 du filtre GMR.

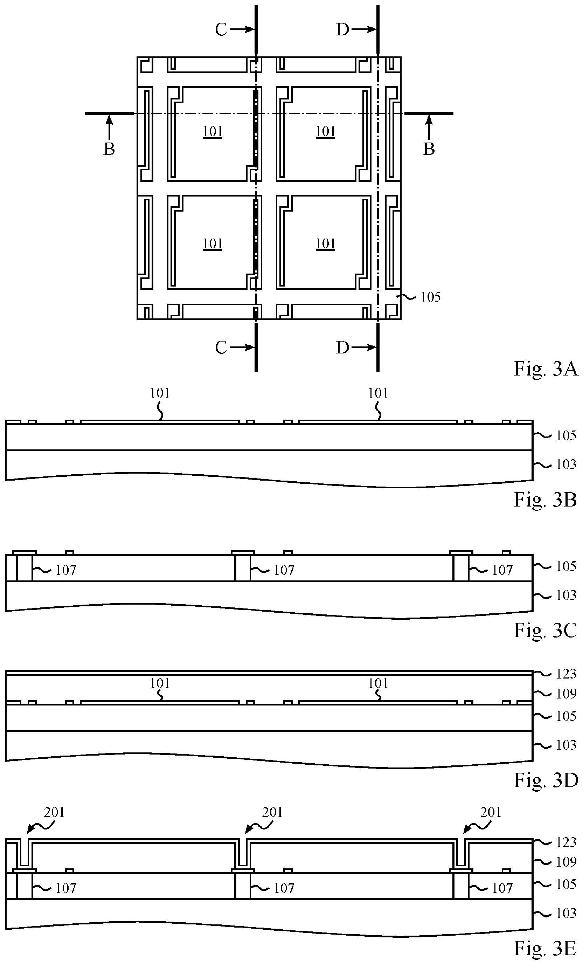

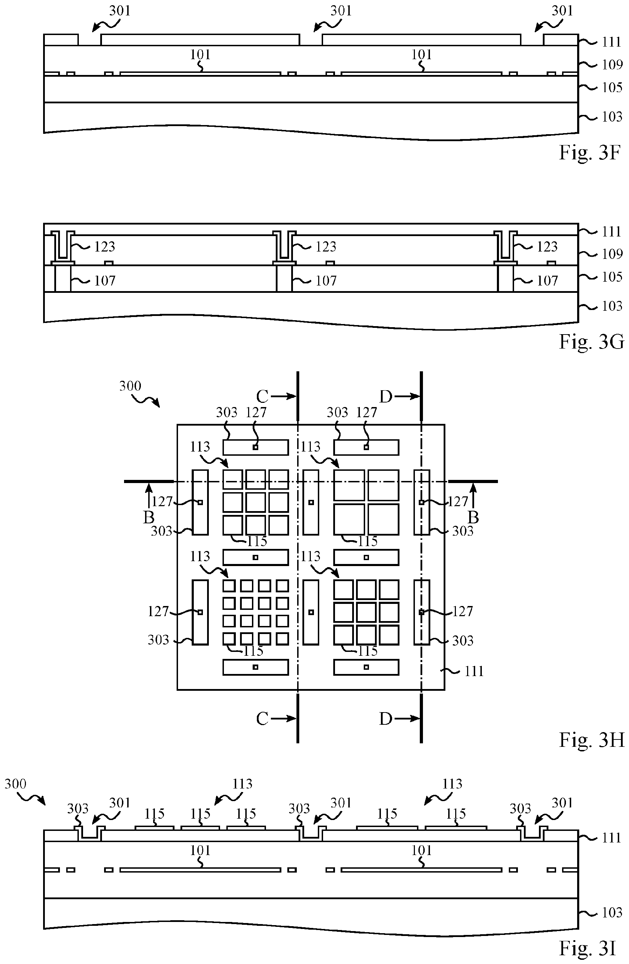

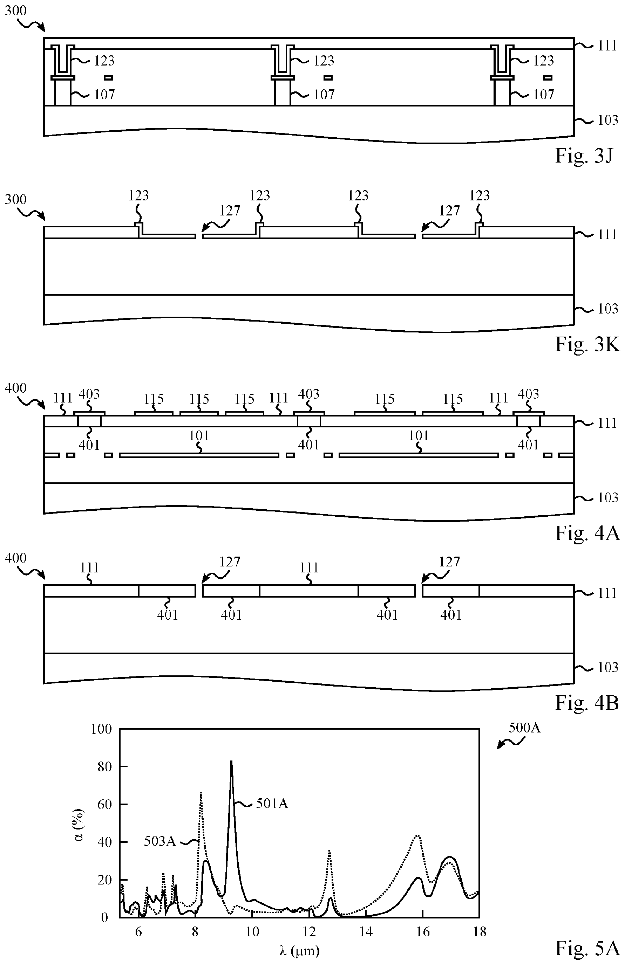

Les figure 3A, figure 3B, figure 3C, figure 3D, figure 3E, figure 3F, figure 3G, figure 3H, figure 3I, figure 3J et figure 3K illustrent, par des vues de dessus et des vues latérales et en coupe, schématiques et partielles, des étapes successives d'un exemple de procédé de fabrication d'un détecteur bolométrique 300 selon un mode de réalisation.

Le procédé de réalisation du détecteur bolométrique 300 présente des éléments en commun avec les procédés de réalisation des détecteurs bolométriques 100 et 200 détaillés ci-dessus. Ces éléments communs ne seront pas détaillés à nouveau ci-après.

La figure 3A est une vue de dessus, schématique et partielle, illustrant une structure identique ou analogue à celle précédemment décrite en relation avec la figure 1A. La figure 3B et la figure 3C sont des vues latérales et en coupe, respectivement selon les plans BB et CC de la figure 3A, de la structure.

La figure 3D et la figure 3E sont des vues latérales et en coupe, respectivement selon les plans BB et CC de la figure 3A, schématiques et partielles, illustrant une structure obtenue à l'issue d'une étape ultérieure de fabrication du détecteur bolométrique 300.

Au cours de cette étape, la couche 109 est déposée du côté de la face supérieure de la structure et les tranchées 201 sont formées à l'aplomb des piliers de soutien 107 comme exposé précédemment en relation avec la figure 2A.

Par ailleurs, au cours de cette étape, la couche isolante 123 est déposée du côté de la face supérieure de la structure. Dans l'exemple illustré, la couche isolante 123 revêt les flancs et le fond des tranchées 201 ainsi que la face supérieure de la couche 109.

La figure 3F et la figure 3G sont des vues latérales et en coupe, respectivement selon les plans BB et CC de la figure 3A, schématiques et partielles, illustrant une structure obtenue à l'issue d'une étape ultérieure de fabrication du détecteur bolométrique 300.

Au cours de cette étape, des parties de la couche isolante 123 situées à l'aplomb des planches bolométriques 101 sont éliminées. Dans l'exemple représenté en figure 3G, des portions de la couche isolante 123 revêtant le fond et les flancs des tranchées 201 sont conservées.

Par ailleurs, au cours de cette étape, la couche diélectrique 111 est déposée du côté de la face supérieure de la structure. Dans l'exemple représenté, la couche 111 revêt les parties de la couche isolante 123 qui subsistent au voisinage des piliers de soutien 107 ainsi que des parties de la face supérieure de la couche 109 non revêtues de la couche isolante 123. Dans l'exemple illustré en figure 3G, la couche 111 comble les tranchées 201. Cet exemple n'est toutefois pas limitatif, la couche 111 pouvant, à titre de variante, ne pas remplir totalement les tranchées 201.

Par ailleurs, au cours de cette étape, des tranchées 301 sont formées, par exemple par photolithographie puis gravure, dans la couche 111. Dans l'exemple représenté, les tranchées 301 s'étendent verticalement dans toute l'épaisseur de la couche 111 depuis sa face supérieure.

La figure 3H est une vue de dessus, schématique et partielle, illustrant une structure obtenue à l'issue d'une étape ultérieure de fabrication du détecteur bolométrique 300. La figure 3I, la figure 3J et la figure 3K sont des vues latérales et en coupe, respectivement selon les plans BB, CC et DD de la figure 3H, illustrant cette même structure.

Au cours de cette étape, une couche électriquement conductrice est déposée du côté de la face supérieure de la structure précédemment décrite en relation avec les figures 3F et 3G. Le réseau de diffraction 113 est ensuite formé à partir de la couche électriquement conductrice, par exemple par photolithographie puis gravure sélective de la couche conductrice avec arrêt sur la couche diélectrique 111 comme exposé précédemment en relation avec la figure 1C. Dans l'exemple représenté, des parties 303 de la couche conductrice revêtant le fond et les flancs des tranchées 301 subsistent à l'issue de la gravure. Les parties 303 de la couche conductrice permettent d'assurer la tenue mécanique du filtre GMR et jouent un rôle d'isolation optique entre les pixels du détecteur 300.

Par ailleurs, au cours de cette étape, les évents 127 de libération sont formés, par exemple dans l'épaisseur des parties 303 de la couche conductrice revêtant le fond des tranchées 301.

La figure 4A et la figure 4B illustrent, par des vues latérales et en coupe, respectivement selon les plans BB et DD de la figure 3H, schématiques et partielles, une étape d'une variante du procédé de fabrication du détecteur bolométrique 300 des figures 3A à 3K.

Les figures 4A et 4B illustrent plus particulièrement une étape de fabrication d'un détecteur bolométrique 400 comprenant le dépôt d'une couche métallique 401 du côté de la face supérieure de la structure précédemment décrite en relation avec les figures 3F et 3G. Dans l'exemple représenté, la couche métallique 401 comble les tranchées 301. La couche métallique 401 est par exemple ensuite amincie, par exemple par CMP, avec arrêt sur la couche diélectrique 111. À l'issue de cette opération, la couche métallique 401 affleure par exemple la face supérieure de la couche 111, et des parties de la couche métallique 401 situées à l'aplomb des planches bolométriques 101 sont éliminées.

À titre de variante, une couche d'oxyde de silicium peut être déposée sur la face supérieure de la couche diélectrique 111 préalablement à la réalisation des tranchées 301. Dans ce cas, les tranchées 301 s'étendent verticalement depuis la face supérieure de la couche d'oxyde de silicium dans toute l'épaisseur de la couche d'oxyde de silicium et de la couche diélectrique 111. L'amincissement de la couche métallique 401 par CMP s'effectue alors avec arrêt sur la couche d'oxyde de silicium. La couche d'oxyde de silicium est éliminée ultérieurement, par exemple par gravure chimique sélective vis-à-vis du matériau de la couche diélectrique 111 et du matériau de la couche métallique 401, par exemple par retrait en présence d'acide fluorhydrique dilué dans le cas où la couche 111 est en silicium amorphe et où la couche 401 est par exemple en tungstène, en cuivre ou en aluminium.

Par ailleurs, au cours de cette étape, une couche électriquement conductrice est déposée du côté de la face supérieure de la structure. Le réseau de diffraction 113 est ensuite formé à partir de la couche électriquement conductrice, par exemple par photolithographie puis gravure sélective avec arrêt sur la couche diélectrique 111 comme exposé précédemment en relation avec la figure 1C. Dans l'exemple représenté, des parties 403 de la couche conductrice revêtant des parties de la couche 401 subsistent à l'issue de la gravure.

Le matériau de la couche conductrice dans lequel est formé le réseau de diffraction 113, et dont subsistent les parties 403 à l'issue de l'étape précédemment décrite en relation avec les figures 4A et 4B, est par exemple identique à celui de la couche 401. À titre de variante, la couche à partir de laquelle est formé le réseau de diffraction 113 et la couche 401 peuvent être en des matériaux, par exemple des métaux, différents.

Par ailleurs, au cours de cette étape, les évents 127 de libération sont formés, par exemple dans l'épaisseur de la couche métallique 401.

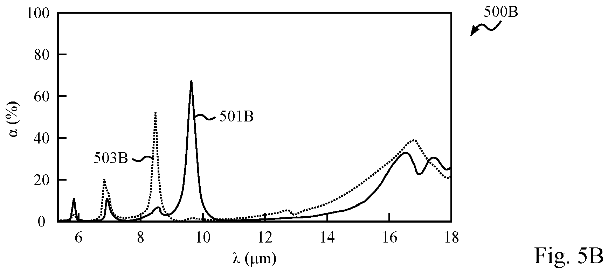

La figure 5A et la figure 5B sont des graphiques illustrant des spectres d'absorption de pixels bolométriques, traduisant une évolution de l'absorption α (en pourcents, %) du pixel bolométrique en fonction de la longueur d'onde λ du rayonnement incident (en micromètres, pm).

La figure 5A est plus précisément un graphique 500A illustrant des spectres d'absorption 501A et 503A de deux pixels d'un détecteur bolométrique usuel, les pixels comprenant des filtres différents. La figure 5B est plus précisément un graphique 500B illustrant des spectres d'absorption 501B et 503B de deux pixels de l'un des détecteurs bolométriques 100, 200, 300 et 400, les pixels comprenant des filtres différents.

Comme cela est illustré en figures 5A et 5B, un avantage des détecteurs bolométriques 100, 200, 300 et 400 décrits ci-dessus tient au fait qu'ils présentent des pertes de réjection réduites et des phénomènes de diaphonie moins importants par rapport aux détecteurs bolométriques existants. Dans les détecteurs bolométriques 100, 200, 300 et 400, le filtre GMR est en appui sur les piliers de soutien 107 des bolomètres, ce qui permet avantageusement de conserver une surface sensible maximale pour les planches bolométriques 101. Par ailleurs, le guide d'ondes 111 du filtre GMR des détecteurs bolométriques 100, 200, 300 et 400 comprend une isolation latérale optique entre les différents pixels, permettant ainsi de limiter la diaphonie et d'améliorer les performances de réjection.

Dans les détecteurs bolométriques 300 et 400, les éléments de support du filtre GMR en appui sur les piliers de soutien 107 comprennent chacun une région de la couche diélectrique 111 dont les flancs et le fond sont revêtus d'une partie de la couche isolante 123. Dans ce cas, les éléments de support du filtre GMR sont ainsi entièrement réalisés en un ou plusieurs matériaux diélectriques. Dans le détecteur bolométrique 200, les éléments de support du filtre GMR comprennent un seul matériau diélectrique.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que des exemples de détecteurs bolométriques 100, 200, 300 et 400 utilisant des couches sacrificielles en oxyde de silicium aient été détaillés ci-dessus, les modes de réalisation décrits ne se limitent pas à ce cas mais s'appliquent plus généralement à tout type de technologie de bolomètre. Par ailleurs, bien que la description prenne pour exemple des détecteurs bolométriques adaptés à capter un rayonnement infrarouge LWIR, cet exemple n'est pas limitatif, les modes de réalisation de la présente description s'appliquant à des détecteurs bolométriques capables de capter un rayonnement infrarouge dans une plage quelconque.

Par ailleurs, bien que des exemples de détecteurs bolométriques 100, 200, 300 et 400 comprenant un filtre pour chaque pixel aient été décrits, les modes de réalisation ne se limitent pas à ces exemples. En particulier, certains pixels du détecteur peuvent être dépourvus de filtre, par exemple dans le cas de pixels blancs ou de pixels large bande. Ainsi, au moins l'un des pixels du détecteur comprend un filtre à mode guidé comprenant un guide d'ondes planaire en appui sur des piliers de soutien d'une planche bolométrique et un réseau de diffraction situé sur et en contact avec le guide d'ondes. La personne du métier est capable de fabriquer un tel dispositif à partir des indications de la description ci-dessus.

Enfin, la mise en oeuvre pratique des modes de réalisation et variantes décrits est à la portée de la personne du métier à partir des indications fonctionnelles données ci-dessus. En particulier, les modes de réalisation décrits ne se limitent pas aux exemples particuliers de matériaux et de dimensions mentionnés dans la présente description.

## Revendications

1. Détecteur bolométrique (100 ; 200 ; 300 ; 400) comprenant une pluralité de pixels comportant chacun une planche bolométrique (101) suspendue au-dessus d'un substrat (103) par des piliers de soutien (107), le détecteur comprenant en outre, pour au moins un desdits pixels, un filtre à mode guidé comprenant un guide d'ondes planaire (111) en appui sur les piliers de soutien (107) et un réseau de diffraction (113) situé sur et en contact avec le guide d'ondes.

2. Détecteur (100 ; 200 ; 300 ; 400) selon la revendication 1, dans lequel le filtre à mode guidé comprend des éléments de support en appui sur les piliers de soutien (107).

3. Détecteur (100) selon la revendication 2, dans lequel chaque élément de support comprend une région électriquement conductrice (125) dont les flancs et le fond sont revêtus d'une couche électriquement isolante (123).

4. Détecteur (200) selon la revendication 2, dans lequel chaque élément de support est constitué d'une seule région diélectrique (111).

5. Détecteur (200) selon la revendication 4, dans lequel au moins deux pixels adjacents comprennent le filtre à mode guidé, les guides d'ondes planaires (111) desdits pixels étant isolés optiquement par une région électriquement conductrice (125) dont les flancs et le fond sont revêtus d'une couche électriquement isolante (123).

6. Détecteur (300 ; 400) selon la revendication 2, dans lequel chaque élément de support comprend une région diélectrique (111) en un premier matériau, les flancs et le fond de ladite région étant revêtus d'une couche isolante (123) en un deuxième matériau, différent du premier matériau.

7. Détecteur (300 ; 400) selon la revendication 6, dans lequel le premier matériau est le silicium amorphe.

8. Détecteur (300 ; 400) selon la revendication 6 ou 7, dans lequel le deuxième matériau est l'alumine.

9. Détecteur (300 ; 400) selon la revendication 6, 7 ou 8, dans lequel au moins deux pixels adjacents comprennent le filtre à mode guidé, les guides d'ondes planaires (111) de desdits pixels étant isolés optiquement par une région électriquement conductrice (303).

10. Détecteur (300 ; 400) selon la revendication 9, dans lequel la région électriquement conductrice (303) et le réseau de diffraction (113) sont en un même matériau, de préférence un métal.

11. Détecteur (300 ; 400) selon la revendication 9, dans lequel la région électriquement conductrice (303) et le réseau de diffraction (113) sont en des matériaux, de préférence des métaux, différents.

12. Détecteur (100 ; 200 ; 300 ; 400) selon l'une quelconque des revendications 1 à 11, dans lequel le réseau de diffraction (113) comprend une pluralité de plots (115) situés sur et en contact avec la face supérieure du guide d'ondes planaire (111).

13. Procédé de fabrication d'un détecteur bolométrique (100 ; 200 ; 300 ; 400) selon l'une quelconque des revendications 1 à 12, comprenant les étapes suivantes :
a) former les piliers de soutien (107) et les planches bolométriques (101) au-dessus du substrat (103) ;
b) déposer une première couche sacrificielle (109) du côté de la face supérieure de la structure ;
c) former, pour ledit au moins un desdits pixels, le guide d'ondes planaire (111) et le réseau de diffraction (113) ;
d) former des vias (121 ; 201) dans toute l'épaisseur de la première couche diélectrique (109) à l'aplomb de chaque pilier de soutien (107) ;
e) déposer une deuxième couche isolante (123) du côté de la face supérieure de la structure ; et
f) déposer une couche électriquement conductrice (125) du côté de la face supérieure de la structure.

14. Procédé selon la revendication 13, dans lequel l'étape f) est mise en oeuvre après l'étape e).

15. Procédé selon la revendication 13, dans lequel l'étape f) est mise en oeuvre avant l'étape c).
